(19) Europäisches Patentamt
European Patent Office
Office européen des brevets

(11) EP 2 270 530 B1

(12) **EUROPEAN PATENT SPECIFICATION**

(45) Date of publication and mention
of the grant of the patent:
**01.05.2013 Bulletin 2013/18**

(51) Int Cl.:
***G01R 33/46*** *(2006.01)*   ***G01R 33/465*** *(2006.01)*

(21) Application number: **09164320.5**

(22) Date of filing: **01.07.2009**

(54) **Method for prediction of lipoprotein content from NMR data**

Verfahren zur Vorhersage des Lipoproteingehalts anhand von NMR-Daten

Procédé de prédiction de contenu de lipoprotéine dans des données NMR

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**05.01.2011 Bulletin 2011/01**

(73) Proprietor: **Københavns Universitet
1165 Copenhagen K (DK)**

(72) Inventors:
• **Engelsen, Søren Balling
2000 Frederiksberg (DK)**
• **Savaroni, Francesco
2900 Hellerup (DK)**
• **Larsen, Flemming Hoffmann
2000 Frederiksberg (DK)**
• **Kristensen, Mette
2300 Copenhagen S (DK)**
• **Astrup, Arne Vernon
2930 Hellerup (DK)**

(74) Representative: **Rasmussen, Torben Ravn et al
Awapatent A/S
Rigensgade 11
1316 Copenhagen K (DK)**

(56) References cited:
**US-A1- 2004 142 496**

• **KRISTENSEN M ET AL: "NMR and interval PLS as reliable methods for determination of cholesterol in rodent lipoprotein fractions" METABOLOMICS, 17 October 2009 (2009-10-17) , XP002558702 DOI: 10.1007/s11306-009-0181-3**

• **DYRBY M ET AL: "Analysis of lipoproteins using 2D diffusion-edited NMR spectroscopy and multi-way chemometrics" ANALYTICA CHIMICA ACTA, ELSEVIER, AMSTERDAM, NL, vol. 531, no. 2, 28 February 2005 (2005-02-28), pages 209-216, XP004756382 ISSN: 0003-2670**

• **BATHEN T F ET AL: "Quantification of plasma lipids and apolipoproteins by use of proton NMR spectroscopy, multivariate and neural network analysis" NMR IN BIOMEDICINE, WILEY, LONDON, GB, vol. 13, no. 5, 1 August 2000 (2000-08-01) , pages 271-288, XP008105223 ISSN: 0952-3480 [retrieved on 2000-06-21]**

• **PETERSEN M ET AL: "Quantification of lipoprotein subclasses by proton nuclear magnetic resonance-based partial least-squares regression models" CLINICAL CHEMISTRY, vol. 51, no. 8, 2005, pages 1457-1461, XP002558703**

• **NORGAARD L ET AL: "Interval partial least-squares regression (iPLS): A comparative chemometric study with an example from near-infrared spectroscopy" APPLIED SPECTROSCOPY, vol. 54, no. 3, 2000, pages 413-419, XP002558704**

• **TSAI MY ET AL: "Comparison of ultracentrifugation and nuclear magnetic resonance spectroscopy in the quantification of triglyceride-rich lipoproteins after an oral fat load" CLINICAL CHEMISTRY, vol. 50, no. 7, 2004, pages 1201-1204, XP002558705**

• **ALA-KORPELA M: "Critical evaluation of 1H NMR metabonomics of serum as a methodology for disease risk assessment and diagnostics" CLIN CHEM LAB MED, vol. 46, no. 1, 18 November 2007 (2007-11-18), pages 27-42, XP002558706**

EP 2 270 530 B1

## Description

## Field of the invention

The present invention relates to a method of predicting the quantity of a component of a lipoprotein entity in a biological sample. In the method, a regression model is prepared from NMR spectra of biological samples from a group of non-fasting subjects, which samples have been analysed using a reference quantification method. By comparing error estimates for NMR subspectra for local multivariate regression analyses with an error estimate for a global multivariate regression analysis, a local multivariate regression model may be selected for preparing the regression coefficients. In one embodiment the multivariate regression analysis is a partial least squares regression analysis. The method is useful for measuring and monitoring fat uptake as a function of diet, lifestyle, and health status. The method may be used for assessment and understanding of disease processes and risks, such as for predicting a risk of developing a cardiovascular disease (CVD).

## Background of the invention

It is currently well-known that the risk of developing a cardiovascular disease (CVD) is correlated with the presence of lipoproteins and lipoprotein entities in the blood. Lipoproteins are commonly quantified in blood samples withdrawn from fasting subjects. However, it is suspected that blood samples may be advantageously analysed soon after the ingestion of a meal. In particular, when triacylglycerols (TAG) are ingested in a meal the TAGs will usually enter circulation within 15 minutes after the meal. The TAGs may enter into circulation in the form of chylomicrons, which generally function to carry TAGs from the intestines to the liver, skeletal muscle, and to adipose tissue. Chylomicrons are large, e.g. 75 to 1200 nm, micellar lipoprotein entities, primarily composed of lipids (e.g. 85%). It is suspected that chylomicrons may represent a marker for development of CVDs in addition to other lipoprotein entities.

WO2005/098463 relates to NMR clinical analysers and methods and computer programs for analysing NMR spectra from biological samples for e.g. lipoproteins. WO2005/098463 suggests to employ multivariate analysis for measuring the lipoprotein classes very low density lipoproteins (VLDL), low density lipoproteins (LDL), high density lipoproteins (HDL) and chylomicrons. However, it is not clear how well the classes may be predicted and differentiated. In particular WO2005/098463 does not demonstrate how chylomicrons may be measured using the method described therein. Furthermore, it is not clear if the method of WO2005/098463 can be used for analysing samples withdrawn from non-fasting subjects.

WO2002/086500 relates to the field of metabonomics, especially chemometric methods for analysing samples, e.g. a biological sample. WO2002/086500 is focused on artherosclerosis and coronary heart disease, and therefore lipoproteins and subclasses of these are of interest to WO2002/086500, since these entities are well-known indicators of risk of these CVDs. Among the chemometric methods of WO2002/086500 are both unsupervised, e.g. principal component analysis (CPA), and supervised (e.g. partial least squares, PLS) methods for analysis of $^1$H and $^{13}$C NMR spectra. WO2002/086500 provides descriptions of the mathematics employed in the chemometric methods, and furthermore examples are given of measurement of lipids and some lipoprotein entities in biological samples. The results of the experiments where NMR-spectra of samples were analysed using supervised multivariate analyses appear to indicate that the method is not able to differentiate fully between the different lipoprotein entities. For example, the results may not yield a quantification of chylomicrons in the blood and samples analysed in WO2002/086500 were derived from subjects having fasted overnight. Thus, it is not evident that the method of WO2002/086500 may be used to predict chylomicrons in a sample from a non-fasting subject.

Petersen et al. (2005, Clin. Chem., 51:8, 1457-1461) employ PLS regression to predict cholesterol and triglyceride concentrations in plasma as well as in VLDL, intermediate density lipoproteins (IDL), LDL, 3 LDL fractions, HDL, and 3 HDL subclasses. Samples analysed by Petersen et al. only comprised blood samples withdrawn from fasting subjects, and the article contains no indication that the employed method and statistics may predict chylomicrons.

The article Dyrby M et al, Analytica Chimica Acta 531:209-216, 2005 discloses a method of predicting the quantity of a component of a lipoprotein entity in a biological sample. More specifically, except for the feature "selecting an interval of chemical shifts and the regression coefficients of the corresponding local multivariate regression analysis based on a comparison of the error estimates of each of the local multivariate regression analyses with the error estimate of the global multivariate regression analysis in such a manner that the error estimate of the selected local multivariate regression analysis is lower than the error estimate of the global multivariate regression analysis", all features defined in claim 1 are known from this article.

There is now a need to provide a better analytical method to analyse biological samples for contents of lipoproteins. Especially, there is a need for an analytical method to analyse for or predict TAG contents in chylomicrons. Likewise, there is a need to provide an analytical method capable of quantifying or predicting the quantity of a lipoprotein or a component of a lipoprotein entity.

It is the aim of the present invention to address these problems.

## Summary of the invention

The present invention relates to a method of predicting the quantity of a component of a lipoprotein entity in a biological sample as defined in claim 1.

The method of the invention is based on a statistical analysis, a multivariate statistical analysis, of a large number of biological samples, which are analysed using a reference quantification method. The statistical analysis of the reference quantification may be used as a basis to prepare regression coefficients for predicting the quantity of a component of a lipoprotein entity in a biological sample. Prediction of the quantity of a component of a lipoprotein entity is relevant for any vertebrate subject, although mammalian vertebrate subjects are preferred. In a certain embodiment the vertebrate subject is human. Lipoproteins and lipoprotein entities are generally indicative of cardiovascular diseases (CVD) and may be used to estimate the risk of an individual of acquiring such disease. In particular, measurement and monitoring of uptake of fat or lipids as a function of parameters such as diet, lifestyle, and health status may be relevant for estimating this risk. The method of the invention advantageously allows analysis of a sample from a non-fasting subject, thus providing data not previously available. Prediction of the quantity of a component of any lipoprotein entity, such as of chylomicrons, of very low density lipoproteins (VLDL), of intermediate density lipoproteins (IDL), of low density lipoproteins (LDL), and of high density lipoproteins (HDL) etc. may thus be considered indicative of the disease and/or health state of an individual, and are therefore relevant for the present invention. However, it is preferred that the lipoprotein entity is a chylomicron. Likewise, it is relevant to predict any component of the lipoprotein entity, although it is preferred that the lipoprotein entity is triacylglycerol.

Any reference quantification method which may quantify the component of the lipoprotein entity may be used in the method of the invention. In one embodiment the reference quantification method is an ultracentrifugation method.

Any biological sample from the vertebrate subject may be employed for quantifying the lipoprotein entity in the biological samples using the reference quantification method provided that the sample is blood, serum or plasma or derived from these. In particular, it is preferred to provide the biological sample from a non-fasting vertebrate subject. It is further preferred that the sample is fresh. Analysis of a sample from a non-fasting subject may provide additional information not available from the traditional analysis of samples withdrawn from fasting subjects. For example, analysis of samples from non-fasting subjects may give an improved estimate of the disease and/or health state of the subject.

The regression coefficients for predicting the quantity of a component of a lipoprotein entity are obtained by comparing the quantification results obtained using the reference quantification method with NMR spectra recorded for the biological samples. Any type of proton, carbon or phosphorus NMR spectra may be subjected to this analytical approach, although it is preferred to subject proton NMR spectra or phosphorus NMR spectra to the analysis. $^1$H or $^{31}$P NMR spectra are highly relevant for biological samples due to the high natural abundance of these two isotopes; although a $^{13}$C NMR spectrum may also be used. It is further preferred that the spectra are one-dimensional, and the spectra may be recorded with or without solvent (e.g. water) suppression. In the method of the invention, the NMR spectra will be subjected to a global multivariate regression analysis. Subsequently, the range of chemical shifts of the NMR spectra is divided into a number of intervals to obtain NMR subspectra, each corresponding to a given interval of chemical shifts. The range of chemical shifts may be divided into any number of intervals; it is preferred that the intervals are equidistant, although this is not a requirement. For example, a NMR ($^1$H) spectrum with chemical shifts ranging from 0.0 to 5.8 ppm may be divided into 16 equidistant intervals. The NMR subspectrum for each interval of chemical shifts is then subjected to a local multivariate regression analysis. This will allow error estimates to be calculated for each local multivariate regression analysis and compare this to the error estimate for the global multivariate regression analysis. Any multivariate regression analysis may be used in the method; in a specific embodiment the multivariate regression analysis is a partial least squares (PLS) regression analysis. Thus, in the method of the invention these error estimates are calculated for the lipoprotein entity as quantified using the reference quantification method. Error estimates may for example be expressed as the root mean squared error of cross-validation (RMSECV) or any other statistical parameter for expressing error estimates. The error estimate for each of the local multivariate regression analyses may be compared to the global multivariate regression analysis, and the inventors have now found that for certain intervals of chemical shifts the local multivariate regression analysis may yield a better error estimate, e.g. as expressed by a lower RMSECV, than found for the global multivariate regression analysis. According to the method of the invention an interval of chemical shifts based on the comparison of the error estimates of the local multivariate regression analyses with the error estimate for the global multivariate regression analysis is now selected, and regression coefficients for this local multivariate regression analysis are then calculated. In one embodiment of the invention an interval corresponding to the chemical shifts comprising the lipid methylene and/or the methyl resonance(s) is(are) selected. Thus, for example the spectral region of 1.05 ppm to 1.4 ppm may be selected for calculation of the regression coefficients for the local multivariate regression analysis, e.g. PLS regression analysis.

In yet another aspect, the invention relates to a NMR analyser as defined in claim 11.

In general, the NMR analyser may comprise any type of NMR spectrometer, although it is preferred that the NMR spectrometer is equipped for recording a proton ($^{1}$H) NMR spectrum or a phosphorus ($^{31}$P) NMR spectrum. The NMR spectrometer may also be equipped for recording a carbon ($^{13}$C) NMR spectrum. The NMR spectrometer may operate at any frequency, for example the NMR spectrometer may operate at or above $^{1}$H Larmor frequencies of 200 MHz, such as at frequencies of about 200, 300, 400, 500, or 600 MHz etc.

It is advantageous that the method of the invention is transferable from spectrometer to spectrometer and from laboratory to laboratory. Therefore in a preferred variant of the invention the method further comprises steps to ensure transferability; these steps may include specifications of protocols for sample preparation, e.g. from blood, plasma, serum etc., specifications of storage conditions of the samples, and specifications of NMR sample preparation protocols. Likewise, the NMR spectrometer may also be specified together with operational parameters, as well as procedures and protocols for calibration of the NMR spectrometer. The processing of the NMR data may also be specified together with quality parameters for the NMR data (e.g. line shape and line width, allowed positional variability of predefined signals, signal-to-noise). In particular, the objective of this embodiment is that any variability created by any of the experimental procedures and steps involved is significantly smaller than the variability related to the concentration of the lipoprotein entity, e.g. chylomicrons, or the component of the lipoprotein entity, e.g. triacylglycerol. Transferability may be demonstrated via instrument and inter-lab cross-calibration tests.

**Brief description of the drawings**

Fig. 1 A representative NMR spectrum of human blood covering the entire lipid region from 0.0 ppm to 5.8 ppm. Insert shows a schematic view of the micellar chylomicron structure.
Fig. 2 An iPLS regression model. Insert A shows the methylene peak according to the sample content of chylomicron TAG. Insert B show the regressions coefficients of the iPLS models together with an average spectrum of 153 blood samples.
Fig. 3 An iPLS regression model as viewed by a predicted (NMR-TAG) versus measured (UC-TAG) plot.

**Detailed description of the invention**

The present invention relates to a method of predicting the quantity of a component of a lipoprotein entity in a biological sample and to an NMR analyser for predicting the quantity of a lipoprotein entity. The invention will now be described in more detail referring to specific embodiments. In order to more fully explain the invention, definitions of the terms employed in this document are given below.

In the context of the present invention the term "lipoproteins entity" refers to any entity found in bodily fluids, such as blood or serum, of a vertebrate subject, e.g. a human being or a mammal, comprising lipids and proteins. Thus, a lipoprotein entity is typically an assembly of lipids and proteins where hydrophobic lipids or lipid derivatives are surrounded by a shell of proteins providing a hydrophilic outer surface to the assembly. This hydrophilic outer surface helps solubilise the lipids in the aqueous bodily fluid, e.g. blood or serum, and the lipoprotein entities generally function to transport lipids around in the vertebrate body. Lipoproteins may be classified according to size and density into chylomicrons, very low density lipoproteins (VLDL), intermediate density lipoproteins (IDL), low density lipoproteins (LDL), and high density lipoproteins (HDL); the classification and the characteristics of the lipoprotein entities is well-described in the literature (see for example JM Berg; JL Tymoczko; L Stryer, Biochemistry, 6th Edition, W.H. Freeman, 2007, New York). A lipoprotein entity may also be referred to as a lipoprotein particle, and the terms may be employed interchangeably. Chylomicrons are preferred as lipoprotein entities in the context of the present invention.

A "component of a lipoprotein entity" may be any component found in the lipoprotein entity. Examples of such components are cholesterol, triglycerides, triacylglycerides (TAG) etc.

In a certain embodiment of the method of the invention, the sample is a fresh sample, e.g. a fresh blood sample. In this context "fresh" refers to a sample, which has not been frozen between withdrawal from the subject and analysis. A sample containing other added substances, such as anticoagulants, e.g. citrate or EDTA, or preservatives, such as sodium azide, is also considered "fresh" if it has not been frozen between withdrawal and analysis.

It is preferred that a sample for analysis in the method of the present invention is withdrawn from a non-fasting subject. In the context of the invention "non-fasting" means that the sample is withdrawn from a subject which does not need to be in a fasting state. A fasting state may occur when the subject is required not to ingest any food in a specified amount of time, such as 6 hours, 12 hours or another specified amount of time, before withdrawing the sample. Thus, when a sample is withdrawn without regard to when the subject ingested food it may be considered to be withdrawn from a non-fasting subject. However, in a specific embodiment the sample is withdrawn at a specified amount of time after the subject has ingested food, e.g. a meal, such as for example 5, 10, 20 or 30 minutes, 1, 2 or 3 hours etc. after ingestion. In yet another embodiment the subject ingests a defined test meal before withdrawing the sample at the specified point of time. A defined test meal may for example contain a specified amount of energy, such as 2, 3, 4, 5 or 6 MJ with a predetermined macronutrient composition, e.g. 15% of the energy (or E%) from protein, 35E% from fat and 50E% from carbohydrates. The defined test meal may also contain indigestible components, such as dietary fibre, e.g. in the range from 0 to 15 g.

The method of the invention refers to a "reference quantification method". This term covers any quantification method that may be employed to quantify a component, such as a component of a lipoprotein entity, in a biological sample. In particular, for the analysis of components, such as TAGs, in samples from blood or serum or the like, methods capable of separating analytes based on parameters such as size and density are relevant. A preferred reference quantification method is ultracentrifugation, or differential centrifugation; this method is described in more detail in e.g. Baumstark MW, Kreutz W, Berg A, Frey I, Keul J. Structure of human low-density lipoprotein subfractions, determined by X-ray small-angle scattering, Biochim. Biophys. Acta 1990; 1037:48-57.

The method of the invention employs a multivariate data analysis. A preferred method is the one known as partial least squares (PLS) regression analysis. Other relevant multivariate regression analyses are collinear ridge regression and principal component regression (PCR), although the invention is not limited to these. Multivariate analysis may advantageously project multivariate data into few dimensions, e.g. in a graphical interface. A general purpose of the multivariate data analysis as used in the present invention is to optimise the predictive power of multivariate data analysis regression models, such as PLS models, and to aid in interpretation. The concepts and terms employed in this context are explained below, also in connection with other parameters and models employed in multivariate data analysis.

"Partial least squares regression" (PLS) is a predictive two-block regression method based on estimated latent variables and is applied to the simultaneous analysis of two data sets (e.g., spectra and physical/chemical tests) on the same objects (H. Martens and T. Næs, Multivariate Calibration (Wiley, New York, 1993), 2nd ed) (e.g., samples of beer or fruit juice). The purpose of the PLS regression is to build a linear model enabling prediction of a desired characteristic **(y)** from a measured spectrum **(x).** In matrix notation we have the linear model **y** = **Xb** where **b** contains the regression coefficients that are determined during the calibration step, and **X** is the matrix of collected spectra. PLS was first applied to evaluate NIR spectra by Martens and Jensen in 1983, ("Partial Least Squares Regression: A New Two Stage NIR Calibration Method" , in Progress in Cereal Chemistry and Technology, J. Holas and J. Kratochvil, Eds. (Elsevier, Amsterdam, 1983), pp. 607-647) and is now used routinely in academia and industry to correlate (rapid) spectroscopic measurements with related chemical/physical data.

"Interval PLS" (iPLS) is an interactive extension to PLS, which develops local PLS models on equidistant subintervals of the full-spectrum region. Its main force is to provide an overall picture of the relevant information in different spectral subdivisions, thereby focusing on important spectral regions and removing interferences from other regions. The sensitivity of the PLS algorithm to noisy variables is highlighted by the informative iPLS plots. Interval PLS models are developed on spectral subintervals of equal width, and the prediction performance of these local models and the global (full-spectrum) model is compared. The comparison is mainly based on the validation parameter RMSECV (root mean squared error of cross-validation), but other parameters such as $r^2$ (squared correlation coefficient), slope, and offset are also evaluated to ensure a comprehensive model overview. Sample and/or measurement abnormalities (outliers) as detected by PLS inner relation plots should generally be removed prior to the application of iPLS. Models based upon the various intervals **(X$_{interval}$)** usually need a different number of PLS components than do full-spectrum models to catch the relevant variation in **y**. This condition is caused by the varying amount of *y*-correlated information carried by the interval variables (the larger the spectral interval, the greater the number of substances that are likely to absorb/interfere) and is also related to the noise/interference carried by the variables. However, the selected model dimension has to be common to all the local models in order to make a comparison possible. In order to favor the "best" spectral region, it is natural to let the simplest interval model (i.e., the one with the smallest number of PLS components) guide the selection of the model dimension. A fair comparison of the global and local models requires that the global and local model dimensions be selected separately.

*Simple Optimization of the Best Interval from Equidistant iPLS.* There is a minimal probability for hitting the optimal interval with the equidistant subdivisions. A more optimal interval might be found by carrying out small adjustments in the interval limits. The optimization performed consists of the following steps: (1) interval shift; (2) changes in interval width: two-sided (symmetrical), one-sided (asymmetrical, left), or one-sided (asymmetrical, right). Each step is initiated with the optimal interval limits from the previous step. The interval limits are changed one variable at a time and evaluated by the RMSECV provided by application of PLS regression to the interval; this approach works in practice but could be done more elegantly.

*Error Measures*

The "root mean square error" (RMSE) in combination with the correlation coefficient (r) is used as a measure of how a given model performs. RMSE is defined as follows:

$$\text{RMSE} = \sqrt{\sum \frac{\left(y_{pred} - y_{ref}\right)^2}{N}}$$

where $y_{prea}$ is the predicted value, $y_{ref}$ is the laboratory measured value, and N is the number of samples.

RMSEC is RMSE calculated from the calibration samples, i.e., a measure of fit. RMSECV is calculated from the cross-validated samples, and RMSEP is calculated from the independent test (or prediction) set (H. Martens and T. Næs, Multivariate Calibration (Wiley, New York, 1993), 2nd ed., S. Wold, Technometrics 20, 397 (1978)). Correspondingly, $r_{cal}$, $r_{cv}$, and $r_{pred}$ are the correlation coefficients for these three situations.

The inventors have now found that a method based on the iPLS method described above may be employed to provide an improved regression model for predicting the quantity of a component of a lipoprotein entity in a biological sample as compared to methods known in the prior art.

A preferred embodiment of the method comprises providing biological samples from a group of non-fasting vertebrate subjects. The vertebrate subjects may be humans, and the samples may be blood samples. For example, blood samples may be withdrawn into tubes containing EDTA, or another compound preventing coagulation of the blood; the samples may also be plasma obtained from the blood samples, e.g. as a supernatant from a centrifugation of the blood.

The lipoprotein entity is then quantified in the biological samples. For example, chylomicrons may be isolated from plasma in an ultracentrifugation step, wherein the plasma is initially overlayed on a salt solution, e.g. of a density 1.006 kg/l. The tubes are then centrifuged in an ultracentrifuge, e.g. at 23 minutes at 30.000 rpm. A relevant ultracentrifuge is an L7-55 from Beckmann Instruments (Palo Alto, CA) using a fixed angle rotor (50.4 Ti, Beckmann Instruments). Following ultracentrifugation the tubes may be sliced at e.g. 45 mm from the bottom, and the TAG concentration measured in the chylomicron (top) and bottom fractions. Total TAG in the plasma sample may be analysed by a colorimetric test kits (Roche TG, Roche Diagnostics GmbH, Mannheim, Germany).

For a group of biological samples analysed using the reference quantification method NMR spectra are then recorded. For example, proton ($^1$H) NMR spectra may be recorded on a NMR spectrometer, such as a Bruker Avance 500 spectrometer; this spectrometer operates at a Larmor frequency of 500.13 MHz for [1]H. The NMR spectra may be recorded using 64 or 128 scans or more and a relaxation time of up to 20 s, e.g. 5 s. It is also possible to reduce the number of scans to e.g. 4 to 8 scans. The NMR spectra may also be phosphorus ($^{31}$P) NMR spectra or carbon ($^{13}$C) spectra.

In a specific setting the Bruker Avance 500 spectrometer was operated as follows (at a magnetic flux density of 11.75 T and a temperature of 310 K):

The spectra were recorded using presaturation followed by a composite 90 degree pulse. The relaxation delay was 5 s during which presaturation was employed using a transmitter position at 4.700 ppm. The 90 degree pulses had duration of 8.0 μs. The acquisition time was 1.573 s acquired as 32k data points using a spectral width of 10416.667 Hz (20.8278 ppm). After 2 dummy scans a total of 64 scans were acquired, requiring 7 min. 21 sec of measurement time for each sample. Prior to Fourier transformation each FID was zero filled to 64k points and apodized by a Lorentzian linebroadening of 0.3 Hz. Phase correction and baseline correction were performed manually. All spectra were referenced to the anomeric proton of α-D-Glucose at 5.23 ppm. Receiver gain was kept constant.

Other settings are also possible, and the NMR parameters and their settings are generally well-known within the art.

The NMR spectra are now correlated with the quantification results obtained using the reference quantification method, e.g. the ultracentrifugation, by subjecting the NMR spectra to a global multivariate regression analysis, e.g. PLS regression analysis. Any number of components may be used in the calculation of the global multivariate regression analysis (e.g. PLS) regression analysis; for example, the global multivariate regression analysis regression analysis may use 1, 2, 3, 4, 5, 6, 7, 8, 9, 10 or more components.

The NMR spectra are now divided into a number of subspectra, by dividing the range of chemical shifts of the NMR spectra into a number of intervals with each corresponding to a given interval. A local multivariate (e.g. PLS) regression analysis is then calculated for each interval, and as for the global regression analysis any number of components may be used in the calculation, e.g. 1, 2, 3, 4, 5, 6, 7, 8, 9, 10 or more components.

Error estimates are calculated for the global and the local regression analysis models. As an example, a global PLS regression analysis for the analysis of TAG correlated with TAG analysed by ultracentrifugation yielded an $r^2$ of 0.90 and a RMSECV of 0.174 mg/g TAG using 3 principal components. In comparison, the NMR spectra were divided into 16 intervals, and it was found that for the interval centered at about 1.28 ppm (in this instance corresponding to a spectral region of chemical shifts from 1.05-1.4 ppm), i.e. the methylene peak, an $r^2$ of 0.92 and a RMSECV of 0.156 mg/g TAG was obtained using 3 principal components. Thus, this local PLS analysis yielded a better result for predicting TAG in the blood samples than the global PLS analysis, and the interval of chemical shifts from 1.05-1.4 ppm was selected for calculation of the regression coefficients.

The thus provided regression coefficients may now be employed to predict the quantity of a component of a lipoprotein entity in a biological sample. In this case, a blood sample is withdraw from a subject and a proton NMR spectrum is recorded for the blood sample. The NMR spectrum is now compared with the regression model to predict the quantity of TAG of chylomicrons in the sample.

The invention may be used to estimate an individual's health and/or disease state to determine a risk of CVDs for that individual. The method may also be employed to estimate the capacity of an ingredient or component of food to diminish lipid uptake, TAG-rich lipoproteins, and in particular chylomicrons by measuring these after ingestion of food containing a relevant component or ingredient.

**Example**

Nuclear Magnetic Resonance and Chemometrics Predicts Chylomicron TAGs in Human Blood

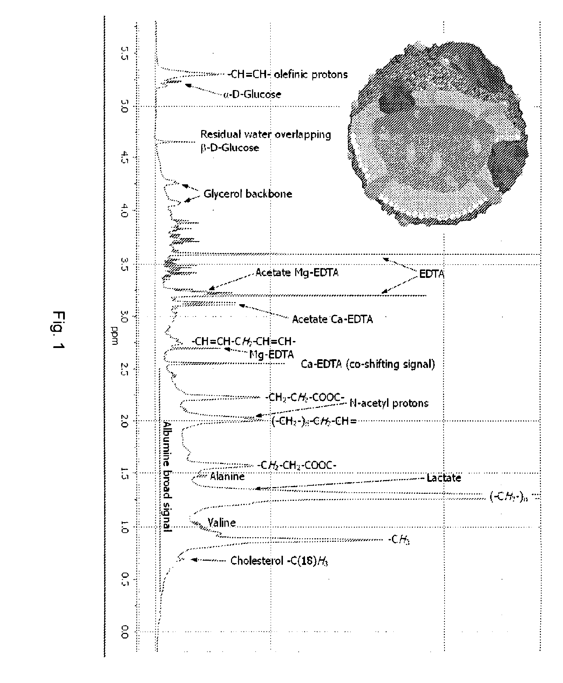

Most of our current knowledge on the link between lipids, lipoprotein metabolism and cardiovascular diseases (CVD) development rely on observations made on fasting individuals. Ironically, we spend the vast majority of our time in a non-fasting postprandial state and recent studies indicate the existence of a relation between the risk for developing CVD and postprandial triacylglycerols (TAGs) (1). When fat is absorbed in the human body it enters the circulation in the form of intestinally derived TAG-rich lipoproteins, essentially chylomicrons, usually within about 15 minutes after finishing a meal. The chylomicrons are released by exocytosis in the villi of the small intestine, and are then secreted into the bloodstream at the thoracic duct's connection with the left subclavian vein. Chylomicrons are large micellar lipoproteins, having a diameter of 75 to 1200 nm, and are primarily composed of triglycerides (85%) and contain some cholesterol and cholesteryl esters (Figure 1 insert). Chylomicrons transport exogenous lipids to liver, adipose, cardiac and skeletal muscle tissue where their triglyceride components are unloaded by the activity of lipoprotein lipase resulting in cholesterol ester-enriched chylomicron remnants, which may internalize in the arteries smooth muscle cells and take part in plaque formation (2). Chylomicrons gather on arterial walls and may be as dangerous as low-density lipoprotein (LDL) cholesterol in causing strokes and heart attacks. Until now LDL cholesterol, which is produced in the liver and delivered to the rest of the body over a period of days after food is ingested, is the primary suspect among cholesterols in the development of coronary artery disease (3). However, it remains elusive why 40% of people who are highly vulnerable to suffering a stroke or heart attacks have low or normal LDL levels. To determine an individual's ability to clear postprandial lipids or the capacity of a food ingredient to diminish lipid uptake, TAG-rich lipoproteins, and in particular chylomicrons can be measured after an oral fat load.

The gold standard analytical method for measuring TAG-rich lipoproteins is density gradient ultracentrifugation (UC). This analysis is very labor-intensive and requires 24 hours of analysis to fractionate the lipoproteins. The number of samples that can be analyzed at the same time is small due the limited capacity of the individual ultracentrifuge. Thus, postprandial lipoprotein metabolism is very limited in large clinical trials. Recently, Tsai et al (4) showed that Nuclear Magnetic Resonance (NMR) spectroscopy may represent an alternative method for the measurement of postprandial TAG-rich lipoproteins in humans. In this paper we will demonstrate, using supervised multivariate pattern recognition on a large sample set, that the quantification of TAG in chylomicrons can be made very precisely and efficiently. The results are validated against the UC method. To demonstrate the performance of the new method, human blood samples were obtained after ingestion of test meals varying in fiber content, as dietary fibers are known to affect postprandial lipoprotein responses (5).

Proton NMR ($^1$H-NMR) spectroscopy has become an indispensable analytical technique for characterization of complex biological samples such as metabolite mapping in tissue and body fluids (6). Lipoproteins have quite similar compositions and thus their subgroups give rise to very similar NMR signals. However, it has been shown that NMR signals of lipoproteins in blood are minimally shifted in frequency due to the different densities of the lipoproteins giving rise to different local magnetic fields (7). Extraction of quantitative information from NMR spectra normally require curve fitting and/or integration of peaks, but for optimal extraction of information in complex matrices a supervised multivariate data mining approach is required such as was employed for lipoprotein subgroups in human blood (8).

The mathematical basis for the fundamental advances in high throughput metabonomic in particular (9) and quantitative spectroscopy in general has largely been due to the use of multivariate models such as principal component analysis (PCA) (10) and partial least squares regression (PLS) (11), and facilitated by the on-going computerized revolution. These techniques, based on latent variables, facilitate an inductive exploratory strategy, which is of fundamental scientific importance as a complement to the ubiquitous deductive research strategies (12). PCA and PLS use a two-dimensional multivariate data evaluation strategy, in which many homologues samples are analyzed simultaneously, in order to extract underlying latent features and to benefit from the first order data advantage (noise reduction, outlier detection, interference compensation). PLS regression applies to the simultaneous analysis of two sets of variables on the same objects and is used in quantitative spectroscopy to correlate the spectroscopic data (**X**-block - fast multivariate measurements) to a univariate physico-chemical data (**y**-block - time consuming and laborious measurements). The main purpose of the regression is to build a model enabling the prediction of the reference UC-TAGs characteristic (**y**) from a measured NMR spectrum (**x**). In matrix notation we have the linear model **y = Xb**, where **b** contains the regression coefficients that are determined during the calibration step. The PLS-calculation starts with a covariance based calculation and, when using mean centered data, the elements of the first latent PLS-factor (calculated as **X'y**) will be proportional to the covariance of the spectral intensities of **X** with respect to the **y** vector of reference measurements. This illustrates that the information in the **X** matrix will be extracted guided, or supervised, by the information in **y.**

A representative NMR spectrum (0.0-5.8 ppm) of human blood is shown in Figure 1 including peak assignment of all the important resonances. This region of the spectrum shows all the broad peaks from lipoprotein TAGs from the strong methyl and methylene resonances respectively centered at 0.87 ppm and 1.28 ppm, respectively, to the broad olefinic resonance at 5.30 ppm with the characteristic overlap with the blood alpha-glucose doublet. Cholesterol methylene resonances are visible at the right sidelobe of the methyl peak at 0.69 ppm. Besides the lipid signals the considered region contains information from the blood sugars, the peptide side-chains and from the EDTA (Ethylenediaminetetraacetic acid) used to prevent the plasma from coagulate.

This report is a part of a larger experimental design investigating the postprandial lipoprotein response as a function of dietary fiber intake. In this study reference blood samples were drawn after 12 hours of fasting (0 minutes), after which the subjects ingested a test meal within 20 minutes and additional blood samples were drawn at 120, 180, 240 and 300 minutes. The study protocol was approved by the Municipal Ethical Committee of Copenhagen and Frederiksberg (Journal no. KF 01-309595). The iso-caloric single test meals provided 4 MJ with the macronutrient composition (15E% from protein, 35E% from fat and 50E% from carbohydrates) but dietary fiber intake ranged from 0 to 15 g. The blood samples were collected in tubes containing EDTA and placed on ice immediately. The samples were centrifuged at 2800g for 15 minutes at 4°C. Plasma was extracted and stored overnight at 4°C before NMR analysis. Chylomicrons were isolated by careful over-laying 3 ml of plasma with 2.5 ml salt solution of density 1.006 kg/l. The UC tubes were centrifuged for 23 minutes at 30.000 rpm in an ultracentrifuge. The tubes were then sliced 45 mm from the bottom, and the TAG concentration was measured by the chylomicron top and bottom fractions containing the smaller lipoproteins and a plasma sample (total TAG) by a colorimetric test kit. The intra- and interassay CVs were 0.6% and 1.4%, respectively. Samples for NMR analysis were prepared by mixing 500 $\mu$l plasma and 60 $\mu$l $D_2O$. $^1$H NMR spectra were acquired at 37°C on a Bruker Avance 500 spectrometer operating at a Larmor frequency of 500.13 MHz for $^1$H using a 120 $\mu$l flow-probe. A pulse sequence using presaturation followed by a composite pulse was used to obtain optimum water suppression. All spectra were acquired employing a spectral width of 10417 Hz, an acquisition time of 1.57 s, a relaxation delay of 5 s and 64 scans.

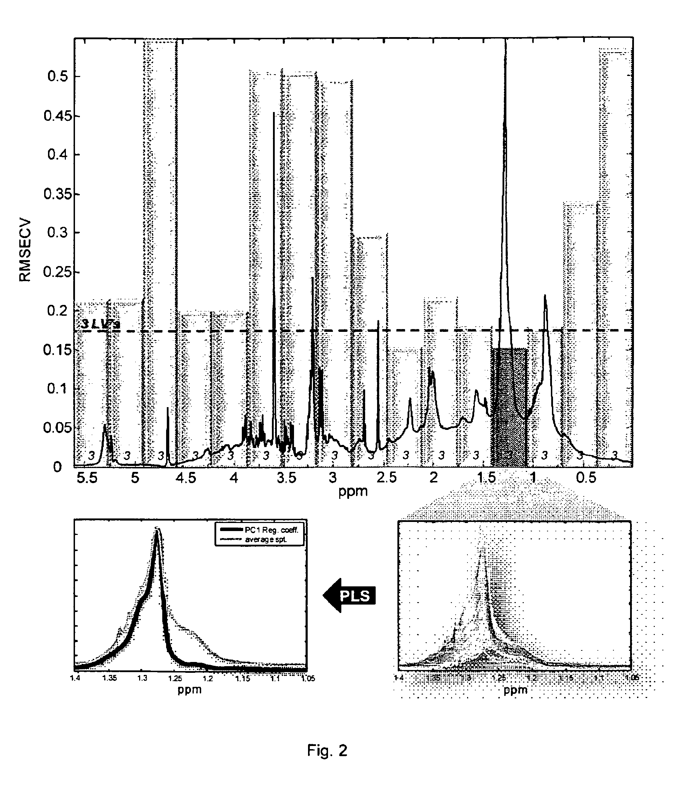

The study design yielded a total of 623 plasma samples to be measured by NMR spectroscopy out of which 153 samples were selected for UC-TAG measurements for calibrating the PLS regression model. The resulting PLS calibration model using the entire spectral information to develop the PLS model yielded a resulting correlation coefficient, $r^2$, of 0.90 and a root-mean-square-error-of-cross-validation (RMSECV) of 0.174 mg/g TAG using just 3 principal components. This result should be compared to a standard deviation of 0.2 mg/g TAG on the ultracentrifugation TAG reference. While this result is exceptionally encouraging an attempt to improve the model and its interpretation was made by application of interval Partial Least Squares (iPLS) regression (13). In this extension to PLS the NMR spectra are divided up into a number of small regions or intervals for each of which a local PLS regression model is calculated. The results of this method are summarized in Figure 2. The horizontal stipulated line shows the RMSECV performance of the global PLS model mentioned above (0.17 mg/g TAG) and the bars show the performances (in term of prediction accuracy) of each of the spectral intervals. Evidently only two spectral regions are able to improve the regression model, when compared to the global regression model: one region which include the vicinal methylene groups to the estergroups of the TAGs and one region which includes the (poly)-methylene protons at centered at 1.28 ppm. The latter region give rise to the best and most parsimonious model for predicting the chylomicron TAGs with a correlation coefficient, $r^2$, of 0.92 and a RMSECV of 0.156 mg/g TAG using only 3 principal components.

The iPLS regression model outlined in Figure 2 is extraordinary strong (explaining 92% percent of the spectral variation) taking into consideration the complex nature of the samples and the laborious reference procedure. The insert (above) in Figure 2 shows the 153 superimposed NMR spectra in this spectral region in which the spectra are colored according to the sample UC-TAG values. This type of interactive data visualization is sometimes very illustrative and it clearly reveals that there is a systematic trend relating higher intensity to higher UC-TAG. Scrutinizing the model it is also found that there is a trend of a higher UC-TAG the more shifted towards higher ppm. However, no univariate model can provide a comparable prediction model. The second insert (below) shows a plot of the regression coefficients (i.e. the variables that are most dominant in the prediction model) superimposed to the average spectrum of the 153 samples. The plot underlines the advantage of multivariate modeling. In this model the methylene protons of the chylomicron TAGs are in a "cage of covariance" and the regression coefficients appear as a much more well-defined (poly)-methylene spectrum than the average spectrum.

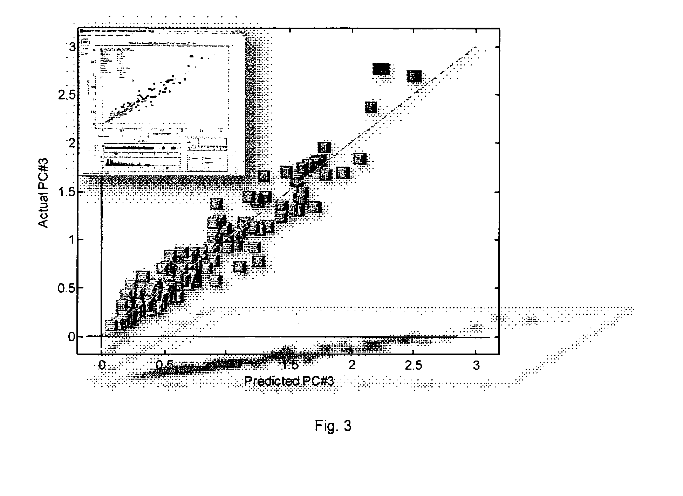

The scatter plot in Figure 3 represents the golden proof of this application. In this plot the predicted TAG values from the 3 component PLS model based on the NMR spectra are plotted against the measured TAG values by ultracentrifugation. The point scatter around the ideal target line (x=y) demonstrates this excellent correlation.

With the escalating obesity epidemic and its co-morbidities and the established relationship between postprandial elevation of lipids and CVD risk, the search for food ingredients which effectively suppress postprandial lipemia has increased in recent years. This rapid measurement of chylomicron TAG is a valuable tool in nutritional research for assessment of absorption of exogenous diet-derived lipids.

The future perspectives in phenotyping for personalized nutrition and personalized drug treatment has only just begun (14). To determine an individual's ability to clear postprandial lipids or the capacity of a food ingredient to diminish lipid uptake, TAG-rich lipoproteins, and in particular chylomicrons must be measured after an oral fat load. The new measurement technique outlined here facilitates ultra-rapid measurement of chylomicron TAGs and creates new opportunities for research in lifestyle diseases and obesity.

References:

1. S. Bansal et al., JAMA-Journal of the American Medical Association 298, 309 (2007).

2. G. D. Kolovou, K. K. Anagnostopoulou, S. S. Daskalopoulou, D. P. Mikhailidis, D. V. Cokkinos, Curr. Med. Chem. 12, 1931 (2005).

3. B. Lamarche et al., Circulation 95, 69 (1997).

4. M. Y. Tsai et al., Clin Chem 50, 1201 (2004).

5. D. Lairon, B. Play, D. Jourdheuil-Rahmani, Journal of Nutritional Biochemistry 18, 217 (2007).

6. J. C. Lindon, J. K. Nicholson, E. Holmes, J. R. Everett, Concepts Magn. Reson. 12, 289 (2000).

7. J. D. Otvos, E. J. Jeyarajah, D. W. Bennett, Clin. Chem. 37, 377 (1991).

8. M. Petersen et al., Clin. Chem. 51, 1457 (2005).

9. J. K. Nicholson, J. Connelly, J. C. Lindon, E. Holmes, Nature Reviews Drug Discovery 1, 153 (2002).

10. H. Hotelling, J. Educ. Psychol. 24, 417 (1933).

11. S. Wold, H. Martens, H. Wold, Lecture Notes in Mathematics 973, 286 (1983).

12. L. Munck, L. Nørgaard, S. B. Engelsen, R. Bro, C. A. Andersson, Chemom. Intell. Lab. Syst. 44, 31 (1998).

13. L. Nørgaard et al., Appl. Spectrosc. 54, 413 (2000).

14. T. A. Clayton et al., Nature 440, 1073 (2006).

**Claims**

1. A method of predicting the quantity of a component of a lipoprotein entity in a biological sample from an NMR spectrum of the biological sample, the lipoprotein entity being selected from the list consisting of chylomicrons, VLDL, IDL, LDL and HDL, the method comprising the steps of

- selecting the type of NMR spectra to be recorded from proton NMR spectra, carbon NMR spectra or phosphorus NMR spectra;

- selecting a range of chemical shifts for the selected type of NMR spectra;

- providing regression coefficients for predicting the quantity of the component of the lipoprotein entity from the NMR spectrum of the biological sample, which regression coefficients are being obtained in the steps of:

   o providing reference biological samples from a group of vertebrate subjects, which reference biological samples are blood, serum or plasma, or the samples are derived from these;

   o quantifying the component of the lipoprotein entity in each of the reference biological samples using a reference quantification method, thereby obtaining a set of reference quantifications;

   o for each of the reference biological samples, recording an NMR spectrum of the selected type over the selected range of chemical shifts, thereby obtaining a set of global NMR spectra;

   o subjecting the set of global NMR spectra for the full selected range of chemical shifts and the set of reference quantifications of the component of the lipoprotein entity to a global multivariate regression analysis to determine global regression coefficients for predicting the quantity of the component of the lipoprotein entity in the biological sample from the NMR spectrum of the biological sample;

   o dividing the range of chemical shifts of the set of global NMR spectra into a plurality of intervals, thereby obtaining a set of NMR subspectra for each of the intervals;

   o subjecting each set of NMR subspectra and the set of reference quantifications of the component of the lipoprotein entity to a local multivariate regression analysis to determine local regression coefficients for predicting the quantity of the component of the lipoprotein entity in the biological sample from the NMR spectrum of the biological sample;

   o calculating a prediction error estimate for the global multivariate regression analysis and for each of the local multivariate regression analyses; and

   o selecting an interval of chemical shifts and the regression coefficients of the corresponding local multivariate regression analysis based on a comparison of the error estimates of each of the local multivariate regression analyses with the error estimate of the global multivariate regression analysis in such a manner that the error estimate of the selected local multivariate regression analysis is lower than the error estimate of the global multivariate regression analysis;

- providing the biological sample from a vertebrate subject;
- recording the NMR spectrum of the biological sample of the selected type over the selected range of chemical shifts;
- selecting the NMR subspectrum from the NMR spectrum of the biological sample which corresponds to the interval of chemical shifts of the selected local multivariate regression analysis;
- predicting the quantity of the component of the lipoprotein entity in the biological sample by comparing the selected NMR subspectrum with a regression model employing the selected regression coefficients.

2. A method according to claim 1, wherein the interval of chemical shifts comprises the lipid methylene and/or the methyl resonance(s).

3. A method according to any one of claims 1 or 2, wherein the biological sample is blood, serum or plasma.

4. A method according to any one of claims 1 to 3, wherein the lipoprotein entity is a chylomicron.

5. method according to any one of claims 1 to 4, wherein the component of the lipoprotein entity is triacylglycerol.

6. A method according to any one of claims 1 to 5, wherein the multivariate regression analysis is a partial least squares (PLS) regression analysis.

7. A method according to any one of claims 1 to 6, wherein the sample is withdrawn at a specified amount of time after the subject has ingested food.

8. A method according to any one of claims 1 to 7, wherein the subject ingests a defined test meal before withdrawing the sample at the specified point of time.

9. A method according to any one of claims 1 to 8, wherein the sample has not been frozen between withdrawal from the subject and analysis.

10. A method according to any one of claims 1 to 9, wherein the reference quantification method is ultracentrifugation.

11. An NMR analyser comprising means arranged to carry out the method of any one of claims 1-10.

**Patentansprüche**

1. Verfahren zum Vorhersagen der Menge einer Komponente einer Lipoproteineinheit in einer biologischen Probe aus einem NMR-Spektrum der biologischen Probe, wobei die Lipoproteineinheit aus der Liste mit Chylomikronen, VLDL, IDL, LDL und HDL ausgewählt ist und das Verfahren die folgenden Schritte umfasst:

- Auswählen des Typs der NMR-Spektren, die aufgezeichnet werden sollen, aus Protonen-NMR-Spektren, Kohlenstoff-NMR-Spektren oder Phosphor-NMR-Spektren,
- Auswählen des Bereichs an chemischen Verschiebungen für den ausgewählten Typ der NMR-Spektren,
- Bereitstellen von Regressionskoeffizienten zum Vorhersagen der Menge der Komponente der Lipoproteineinheit aus dem NMR-Spektrum der biologischen Probe, wobei die Regressionskoeffizienten in den folgenden Schritten erhalten werden:

o Bereitstellen biologischer Referenzproben von einer Gruppe von Vertebratenindividuen, wobei es sich bei den biologischen Referenzproben um Blut, Serum oder Plasma handelt oder die Proben von diesen herrühren,
o Quantifizieren der Komponente der Lipoproteineinheit in jeder der biologischen Referenzproben unter Verwendung eines Referenz-Quantifizierungsverfahrens, wodurch ein Satz von Referenz-Quantifizierungen erhalten wird,
o Aufzeichnen eines NMR-Spektrums des ausgewählten Typs für jede der biologischen Proben über den ausgewählten Bereich an chemischen Verschiebungen, wodurch ein Satz von globalen NMR-Spektren erhalten wird,
o Unterziehen des Satzes von globalen NMR-Spektren für den vollen ausgewählten Bereich an chemischen Verschiebungen und des Satzes von Referenz-Quantifizierungen der Komponente der Lipoproteineinheit einer globalen multivariaten Regressionsanalyse zum Bestimmen von globalen Regressionskoeffizienten für das Vorhersagen der Menge der Komponente der Lipoproteineinheit in der biologischen Probe aus dem NMR-Spektrum der biologischen Probe,
o Unterteilen des Bereichs an chemischen Verschiebungen des Satzes von globalen NMR-Spektren in eine Mehrzahl an Intervallen, wodurch ein Satz von NMR-Subspektren für jedes der Intervalle erhalten wird,

o Unterziehen jedes Satzes von NMR-Subspektren und des Satzes von Referenz-Quantifizierungen der Komponente der Lipoproteineinheit einer lokalen multivariaten Regressionsanalyse zum Bestimmen von lokalen Regressionskoeffizienten für das Vorhersagen der Menge der Komponente der Lipoproteineinheit in der biologischen Probe aus dem NMR-Spektrum der biologischen Probe,

o Berechnen einer Vorhersagefehlerabschätzung für die globale multivariate Regressionsanalyse und für jede lokale multivariate Regressionsanalyse und

o Auswählen des Intervalls an chemischen Verschiebungen und der Regressionskoeffizienten der entsprechenden lokalen multivariaten Regressionsanalyse auf der Basis eines Vergleichs der Fehlerabschätzungen für jede der lokalen multivariaten Regressionsanalysen mit der Fehlerabschätzung der globalen multivariaten Regressionsanalyse derart, dass die Fehlerabschätzung der ausgewählten lokalen multivariaten Regressionsanalyse kleiner ist als die Fehlerabschätzung der globalen multivariaten Regressionsanalyse,

- Bereitstellen der biologischen Probe von einem Vertebratenindividuum,
- Aufzeichnen des NMR-Spektrums des ausgewählten Typs über den ausgewählten Bereich an chemischen Verschiebungen für die biologische Probe,
- Auswählten des NMR-Subspektrums aus dem NMR-Spektrum der biologischen Probe, das dem Intervall an chemischen Verschiebungen der ausgewählten lokalen multivariaten Regressionsanalyse entspricht,
- Vorhersagen der Menge der Komponente der Lipoproteineinheit in der biologischen Probe durch Vergleichen des ausgewählten NMR-Subspektrums mit einem Regressionsmodell, wobei die ausgewählten Regressionskoeffizienten eingesetzt werden.

**2.** Verfahren nach Anspruch 1, wobei das Intervall an chemischen Verschiebungen die Lipid-Methylen- und/oder die -Methyl-Resonanz(en) umfasst.

**3.** Verfahren nach einem der Ansprüche 1 oder 2, wobei es sich bei der biologischen Probe um Blut, Serum oder Plasma handelt.

**4.** Verfahren nach einem der Ansprüche 1 bis 3, wobei die Lipoproteineinheit ein Chylomikron ist.

**5.** Verfahren nach einem der Ansprüche 1 bis 4, wobei die Komponente der Lipoproteineinheit Triacylglycerin ist.

**6.** Verfahren nach einem der Ansprüche 1 bis 5, wobei die multivariate Regressionsanalyse eine Regressionsanalyse nach der Methode der partiellen kleinsten Fehlerquadrate (engl. partial least squares, PLS) ist.

**7.** Verfahren nach einem der Ansprüche 1 bis 6, wobei die Probe nach einer festgelegten Zeitspanne, nachdem das Individuum Nahrung aufgenommen hat, entnommen wird.

**8.** Verfahren nach einem der Ansprüche 1 bis 7, wobei das Individuum eine definierte Testmahlzeit aufnimmt, bevor die Probe zu dem festgelegten Zeitpunkt entnommen wird.

**9.** Verfahren nach einem der Ansprüche 1 bis 8, wobei die Probe zwischen der Entnahme aus dem Individuum und der Analyse nicht eingefroren wird.

**10.** Verfahren nach einem der Ansprüche 1 bis 9, wobei es sich bei dem Referenz-Quantifizierungsverfahren um Ultrazentrifugation handelt.

**11.** NMR-Analysegerät, umfassend Mittel, die dafür ausgelegt sind, das Verfahren nach einem der Ansprüche 1-10 durchzuführen.

**Revendications**

**1.** Méthode de prédiction de la quantité d'un composant d'une entité de lipoprotéine dans un échantillon biologique à partir d'un spectre RMN de l'échantillon biologique, l'entité de lipoprotéine étant choisie dans la liste constituée par les chylomicrons, les VLDL, les IDL, les LDL et les HDL, la méthode comprenant les étapes consistant à :

- sélectionner le type de spectres RMN à enregistrer parmi les spectres de RMN du proton, les spectres de RMN du carbone ou les spectres de RMN du phosphore ;
- sélectionner une gamme de déplacements chimiques pour le type sélectionné de spectres RMN ;
- fournir des coefficients de régression pour prédire la quantité de composant de l'entité de lipoprotéine à partir du spectre RMN de l'échantillon biologique, lesquels coefficients de régression sont obtenus dans les étapes consistant à :

* fournir des échantillons biologiques de référence issus d'un groupe de sujets vertébrés, lesquels échantillons biologiques de référence sont du sang, du sérum ou du plasma, ou les échantillons sont dérivés de ceux-ci ;

* quantifier le composant de l'entité de lipoprotéine dans chacun des échantillons biologiques de référence en utilisant une méthode de quantification de référence, conduisant ainsi à un set de quantifications de référence ;

* pour chacun des échantillons biologiques de référence, enregistrer un spectre RMN du type sélectionné sur la gamme sélectionnée de déplacements chimiques, conduisant ainsi à un set de spectres RMN globaux ;

* soumettre le set de spectres RMN globaux pour la gamme sélectionnée totale de déplacements chimiques et le set de quantifications de référence du composant de l'entité de lipoprotéine à une analyse de régression multivariable globale afin de déterminer les coefficients de régression globale pour prédire la quantité de composant de l'entité de lipoprotéine dans l'échantillon biologique à partir du spectre RMN de l'échantillon biologique ;

* diviser la gamme de déplacements chimiques du set de spectres RMN globaux en une pluralité d'intervalles, conduisant ainsi à un set de sous-spectres RMN pour chacun des intervalles ;

* soumettre chaque set de sous-spectres RMN et le set de quantifications de référence du composant de l'entité de lipoprotéine à une analyse de régression multivariable locale afin de déterminer les coefficients de régression locale pour prédire la quantité de composant de l'entité de lipoprotéine de l'échantillon biologique à partir du spectre RMN de l'échantillon biologique ;

* calculer une estimation de l'erreur de prédiction pour l'analyse de régression multivariable globale et pour chacune des analyses de régression multivariable locale ; et

* sélectionner un intervalle de déplacements chimiques et les coefficients de régression de l'analyse de régression multivariable locale correspondante sur la base d'une comparaison des estimations d'erreur de chacune des analyses de régression multivariable locale avec l'estimation d'erreur de l'analyse de régression multivariable globale d'une manière telle que l'estimation d'erreur de l'analyse de régression multivariable locale sélectionnée soit inférieure à l'estimation d'erreur de l'analyse de régression multivariable globale ;

- fournir l'échantillon biologique à partir d'un sujet vertébré ;
- enregistrer le spectre RMN de l'échantillon biologique du type sélectionné sur la gamme sélectionnée de déplacements chimiques ;
- sélectionner le sous-spectre RMN à partir du spectre RMN de l'échantillon biologique qui correspond à l'intervalle de déplacements chimiques de l'analyse de régression multivariable locale sélectionnée ;
- prédire la quantité de composant de l'entité de lipoprotéine dans l'échantillon biologique en comparant le sous-spectre RMN sélectionné avec un modèle de régression employant les coefficients de régression sélectionnés.

2. Méthode selon la revendication 1, dans laquelle l'intervalle de déplacements chimiques comprend la ou les résonances des groupements méthylène et/ou méthyle lipidiques.

3. Méthode selon l'une quelconque des revendications 1 ou 2, dans laquelle l'échantillon biologique est du sang, du sérum ou du plasma.

4. Méthode selon l'une quelconque des revendications 1 à 3, dans laquelle l'entité de lipoprotéine est un chylomicron.

5. Méthode selon l'une quelconque des revendications 1 à 4, dans laquelle l'entité de lipoprotéine est un triacylglycérol.

6. Méthode selon l'une quelconque des revendications 1 à 5, dans laquelle l'analyse de régression multivariable est une analyse de régression des moindres carrés partiels (PLS).

7. Méthode selon l'une quelconque des revendications 1 à 6, dans laquelle l'échantillon est prélevé après une quantité spécifiée de temps après que le sujet a ingéré des aliments.

8. Méthode selon l'une quelconque des revendications 1 à 7, dans laquelle le sujet ingère un repas test défini avant prélèvement de l'échantillon au point dans le temps spécifié.

9. Méthode selon l'une quelconque des revendications 1 à 8, dans laquelle l'échantillon n'a pas été congelé entre le prélèvement à partir du sujet et l'analyse.

10. Méthode selon l'une quelconque des revendications 1 à 9, dans laquelle la méthode de quantification de référence est l'ultracentrifugation.

11. Analyseur RMN comprenant un moyen conçu pour mettre en oeuvre la méthode selon l'une quelconque

**EP 2 270 530 B1**

des revendications 1-10.

Fig. 1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005098463 A

- WO 2002086500 A

**Non-patent literature cited in the description**

- **PETERSEN et al.** *Clin. Chem.,* 2005, vol. 51 (8), 1457-1461
- **DYRBY M et al.** *Analytica Chimica Acta,* 2005, vol. 531, 209-216
- **JM BERG ; JL TYMOCZKO ; L STRYER.** Biochemistry. W.H. Freeman, 2007
- **BAUMSTARK MW ; KREUTZ W ; BERG A ; FREY I ; KEUL J.** Structure of human low-density lipoprotein subfractions, determined by X-ray small-angle scattering. *Biochim. Biophys. Acta,* 1990, vol. 1037, 48-57
- **H. MARTENS ; T. NÆS.** Multivariate Calibration. Wiley, 1993
- Partial Least Squares Regression: A New Two Stage NIR Calibration Method. **MARTENS ; JENSEN.** Progress in Cereal Chemistry and Technology. Elsevier, 1983, 607-647
- **S. WOLD.** *Technometrics,* 1978, vol. 20, 397
- **S. BANSAL et al.** *JAMA-Journal of the American Medical Association,* 2007, vol. 298, 309
- **G. D. KOLOVOU ; K. K. ANAGNOSTOPOULOU ; S. S. DASKALOPOULOU ; D. P. MIKHAILIDIS ; D. V. COKKINOS.** *Curr. Med. Chem.,* 2005, vol. 12, 1931
- **B. LAMARCHE et al.** *Circulation,* 1997, vol. 95, 69

- **M. Y. TSAI et al.** *Clin Chem,* 2004, vol. 50, 1201
- **D. LAIRON ; B. PLAY ; D. JOURDHEUIL-RAHMANI.** *Journal of Nutritional Biochemistry,* 2007, vol. 18, 217
- **J. C. LINDON ; J. K. NICHOLSON ; E. HOLMES ; J. R. EVERETT.** *Concepts Magn. Reson,* 2000, vol. 12, 289
- **J. D. OTVOS ; E. J. JEYARAJAH ; D. W. BENNETT.** *Clin. Chem.,* 1991, vol. 37, 377
- **M. PETERSEN et al.** *Clin. Chem.,* 2005, vol. 51, 1457
- **J. K. NICHOLSON ; J. CONNELLY ; J. C. LINDON ; E. HOLMES.** *Nature Reviews Drug Discovery,* 2002, vol. 1, 153
- **H. HOTELLING.** *J. Educ. Psychol.,* 1933, vol. 24, 417
- **S. WOLD ; H. MARTENS ; H. WOLD.** *Lecture Notes in Mathematics,* 1983, vol. 973, 286
- **L. MUNCK ; L. NØRGAARD ; S. B. ENGELSEN ; R. BRO ; C. A. ANDERSSON.** *Chemom. Intell. Lab. Syst.,* 1998, vol. 44, 31
- **L. NØRGAARD et al.** *Appl. Spectrosc.,* 2000, vol. 54, 413
- **T. A. CLAYTON et al.** *Nature,* 2006, vol. 440, 1073